# EUROPEAN PATENT APPLICATION

(11) **EP 4 852 624 A1**
(43) Date of publication of application: **09.12.2026**
(21) Application number: 25757564.7
(22) Date of filing: 14.01.2025
(51) Int. Cl.: H05K 1/02, H01Q 1/50

(54) **CIRCUIT BOARD ASSEMBLY AND ELECTRONIC DEVICE**

(30) Priority: 21.02.2024 CN 202410195712
(71) Applicant: HUAWEI TECHNOLOGIES CO., LTD., Shenzhen, Guangdong 518129 (CN)
(72) Inventor: XIONG, Zhenmin, Shenzhen, Guangdong 518129 (CN); LI, Heng, Shenzhen, Guangdong 518129 (CN); TANG, Wei, Shenzhen, Guangdong 518129 (CN)
(74) Representative: Huawei European IPR
(86) International application number: PCT/CN2025/072220
(87) International publication number: WO 2025/175967

(57) **Abstract**

Embodiments of this application provide a circuit board assembly and an electronic device, and relate to the field of electronic technologies. The circuit board assembly includes a first circuit board and a first spring contact. A portion of the first circuit board is located in a clearance area of an antenna of the electronic device. The first spring contact is located in the clearance area, and one end of the first spring contact, is electrically connected to the portion, located in the clearance area, of the first circuit board, and the other end is configured to be grounded. By providing the first spring contact in the circuit board assembly and implementing grounding through the first spring contact, current return can be achieved. The first spring contact has elasticity, so that reliability and stability of the electrical connection between the first spring contact and the first circuit board can be effectively improved, and ground impedance of the circuit board assembly can be effectively reduced. In addition, the first spring contact can further effectively avoid problems such as poor contact that may occur during the grounding process of the circuit board assembly, and avoid a PIM effect caused by the poor contact, thereby effectively improving operation reliability and stability of the antenna, and thus improving communication experience of a user.

## Description

This application claims priority to Chinese Patent Application No. 202410195712.7, filed with the China National Intellectual Property Administration on February 21, 2024 and entitled "CIRCUIT BOARD ASSEMBLY AND ELECTRONIC DEVICE", which is incorporated herein by reference in its entirety.

### TECHNICAL FIELD

This application relates to the field of electronic technologies, and in particular, to a circuit board assembly and an electronic device.

### BACKGROUND

With the continuous development and evolution of electronic technologies, consumer electronic products such as mobile phones, tablets, and notebook computers have become increasingly prevalent in people's lives. With the continuous development of terminal electronic device technologies, the communication function, as one of the main functions of an electronic device, has consistently attracted attention.

An electronic device usually includes a communication antenna. The communication antenna may transmit and receive signals to implement communication of the electronic device. An electronic component such as a circuit board is usually further disposed around the communication antenna. A signal transmitted by the antenna is radiated to the circuit board, thereby affecting radiation efficiency of the antenna. Therefore, the circuit board is usually grounded to allow a current on the circuit board to return, thereby reducing the impact of the circuit board on the radiation efficiency of the antenna. Currently, the circuit board is typically grounded through bonding to a solder pillar to achieve current return.

However, in the foregoing grounding manner of the circuit board, ground impedance of the circuit board is relatively high. In addition, reliability of the solder pillar connection is poor, which generates a passive intermodulation (passive intermodulation, PIM for short) effect, thereby reducing the radiation efficiency of the antenna.

### SUMMARY

Embodiments of this application provide a circuit board assembly and an electronic device, to effectively avoid problems such as poor contact that may occur in a grounding process of the circuit board assembly, and avoid a PIM effect caused by the poor contact, thereby effectively improving operation reliability and stability of an antenna.

According to a first aspect of this application, a circuit board assembly is provided, including a first circuit board and a first spring contact. The first circuit board is configured to be disposed in an electronic device, and a portion of the first circuit board is located in a clearance area of an antenna of the electronic device. The first spring contact is located in the clearance area, one end of the first spring contact is electrically connected to the portion, located in the clearance area, of the first circuit board, and the other end of the first spring contact is configured to be grounded.

In this embodiment of this application, the first spring contact is disposed in the circuit board assembly and grounding is implemented through the first spring contact, so that current return is achieved. The first spring contact has elasticity, so that reliability and stability of the electrical connection between the first spring contact and the first circuit board can be effectively improved, and ground impedance of the circuit board assembly can be effectively reduced. In addition, the first spring contact can further effectively avoid problems such as poor contact that may occur in a grounding process of the circuit board assembly, and avoid a PIM effect caused by the poor contact, thereby effectively improving operation reliability and stability of the antenna, and thus improving communication experience of a user.

In a possible implementation, a bracket is further included. The bracket includes a first surface and a second surface opposite to each other. At least a portion of the first circuit board is located on the first surface of the bracket, and the second surface faces the first spring contact. The first circuit board is insulated from and connected to the bracket.

The bracket may support the first circuit board, so that the first circuit board is in a flattened state, which can effectively reduce or avoid bending deformation of the first circuit board. In this way, it can be convenient to arrange an electronic element on the first circuit board, and reliability and stability of disposing the electronic element on the first circuit board can be improved.

In a possible implementation, the first circuit board includes a main body portion and an extension portion. The main body portion is located on the first surface and is insulated from and connected to the first surface, and one end of the main body portion is located in the clearance area. One end of the extension portion is connected to the one end, located in the clearance area, of the main body portion, and the other end of the extension portion extends toward the second surface of the bracket. The one end of the first spring contact is electrically connected to the extension portion.

A radiated signal from the antenna may be radiated to the one end, located in the clearance area of the antenna, of the main body portion. A current signal radiated to the main body portion may flow from the main body portion to the extension portion, then flow from the extension portion to the first spring contact, and finally return through the first spring contact, thereby achieving current return on the first circuit board.

In a possible implementation, the extension portion includes a first extension portion and a second extension portion connected to each other. One end of the first extension portion is connected to the main body portion, and the first extension portion extends from the first surface of the bracket toward the second surface. The second extension portion is located on the second surface of the bracket and is insulated from and connected to the second surface. The first spring contact is electrically connected to the second extension portion.

A signal current on the antenna may be radiated to the one end, located in the clearance area, of the main body portion, then sequentially flow from the main body portion to the first extension portion and the second extension portion, and finally flow from the second extension portion to the first spring contact, thereby returning through the first spring contact.

In a possible implementation, a surface, facing the first spring contact, of the second extension portion has an exposed metal surface, and the first spring contact is electrically connected to the exposed metal surface. The exposed metal surface can effectively improve the reliability and stability of the electrical connection between the first spring contact and the first circuit board, and can effectively reduce or avoid a case such as intermittent contact or poor contact between the first spring contact and the first circuit board, thereby effectively improving stability of current return on the first circuit board.

In a possible implementation, a reinforcing structure is further included. The reinforcing structure is located between the second extension portion and the second surface of the bracket, and is connected to the second extension portion and the second surface of the bracket. The reinforcing structure has high rigidity and strength, which can effectively reduce or avoid deformation of the bracket under the restoring force of the first spring contact, prevent the deformation of the bracket from affecting the electrical connection between the second extension portion and the first spring contact, and avoid intermittent contact caused by poor contact between the second extension portion and the first spring contact. Thus, reliability and stability of the electrical connection between the first spring contact and the second extension portion can be effectively improved, thereby effectively improving stability of current conduction between the first circuit board and the first spring contact, and improving reliability of current return.

In a possible implementation, an insulating adhesive is further included. The reinforcing structure is insulated from and connected to the second extension portion through the insulating adhesive. In this way, separation between the second extension portion and the reinforcing structure can be effectively reduced or avoided, and reliability and stability of the connection between the second extension portion and the reinforcing structure can be effectively improved, thereby helping improve overall structural stability of the circuit board assembly.

In a possible implementation, the reinforcing structure is insulated from and connected to the second surface of the bracket through an insulating adhesive layer. In this way, separation between the reinforcing structure and the bracket can be reduced or avoided, thereby effectively improving reliability and stability of the connection between the reinforcing structure and the bracket, and improving structural stability of the circuit board assembly.

In a possible implementation, a conductive layer is further included. One end of the conductive layer is electrically connected to the first circuit board; and the other end of the conductive layer is electrically connected to the first spring contact. At least a portion of the conductive layer is configured to be located in the clearance area.

A current radiated from the antenna to the first circuit board may flow to the conductive layer, then flow to the first spring contact through the conductive layer, and finally return to ground through the first spring contact. The conductive layer has good conductivity, which can effectively improve ground impedance between the first circuit board and the first spring contact, thereby effectively improving efficiency of current return on the first circuit board.

In a possible implementation, the conductive layer includes a first conductive layer and a second conductive layer. The first conductive layer is electrically connected to the second conductive layer. The first conductive layer is located between the first surface of the bracket and the portion, located in the clearance area, of the first circuit board, and is electrically connected to the first circuit board. The second conductive layer is located between the second surface of the bracket and the first spring contact, and is electrically connected to the first spring contact.

The current radiated from the antenna to the first circuit board may first flow to the first conductive layer, then flow to the second conductive layer through the first conductive layer, then flow to the first spring contact through the second conductive layer, and finally return to ground through the first spring contact. The first conductive layer and the second conductive layer have good conductivity, which can reduce connection impedance between the first circuit board and the first spring contact, and help reduce ground impedance of the circuit board assembly, thereby improving efficiency of ground return of the circuit board assembly.

In a possible implementation, the conductive layer is located on the second surface of the bracket and is located between the second surface of the bracket and the first spring contact; and the conductive layer is electrically connected to the first spring contact.

In a possible implementation, there is a bent portion at one end, located in the clearance area, of the first circuit board. The bent portion extends from the first surface of the bracket toward the second surface of the bracket, and the one end of the conductive layer is electrically connected to the first circuit board through the bent portion. The current radiated from the antenna to the first circuit board may first flow to the bent portion of the first circuit board, then flow to the conductive layer through the bent portion of the first circuit board, then flow to the first spring contact through the conductive layer, and finally return to ground through the first spring contact.

In a possible implementation, the conductive layer is a nickel-gold layer. The nickel-gold layer has good conductivity, which can effectively improve ground impedance between the conductive layer and the first spring contact, thereby effectively improving efficiency of current return on the first circuit board. In addition, the nickel-gold layer has good oxidation resistance, which can effectively reduce or avoid oxidation of the conductive layer, thereby helping improve stability and reliability of the conductive layer.

In a possible implementation, the bracket is a plastic bracket. The plastic bracket is lightweight and has low costs, which can effectively reduce an overall weight of the circuit board assembly and thus lower material costs of the circuit board assembly. In addition, the plastic bracket has a good insulating property, which can insulate and isolate the first circuit board, reduce or avoid circuit conduction between the first circuit board and other components, and prevent the conduction between the first circuit board and the other components from affecting normal operation of the circuit board assembly, thereby helping improve overall operation reliability and stability of the circuit board.

In a possible implementation, a second circuit board is further included. The first spring contact is located between the first circuit board and the second circuit board, the other end of the first spring contact is electrically connected to the second circuit board, and the first spring contact is grounded through the second circuit board.

The second circuit board may be configured to charge a charging coil on the first circuit board, and the first spring contact may be grounded through the second circuit board, so that a radiated current on the first circuit board may sequentially return through the first spring contact and the second circuit board, to avoid adverse impact of the radiated current on the first circuit board on normal radiation of the antenna.

In a possible implementation, a second spring contact is further included. One end of the second spring contact is electrically connected to the second circuit board, and the other end of the second spring contact is configured to be grounded to a middle frame of the electronic device. The second spring contact has elasticity, so that reliability and stability of the electrical connection between the second spring contact and each of the second circuit board and the middle frame can be effectively improved, and a case such as poor contact or intermittent contact between the second spring contact and each of the second circuit board and the middle frame can be effectively reduced or avoided, thereby effectively improving reliability and stability of grounding of the second spring contact.

In a possible implementation, the other end of the first spring contact is configured to be electrically connected to a middle frame of the electronic device, to implement grounding. The current radiated from the antenna to the first circuit board may flow to the first spring contact, and then flow to the middle frame of the electronic device through the first spring contact, thereby achieving current return.

In a possible implementation, the first circuit board is a flexible printed circuit. The flexible printed circuit is flexible, can be freely bent and folded, and can be arbitrarily arranged and adjusted based on use requirements, thereby meeting use requirements of different scenarios and providing high flexibility.

In a possible implementation, a charging coil is further included. The charging coil is located on the first circuit board, and at least a portion of the charging coil is configured to be located in the clearance area. In this way, a distance between the charging coil and a frame of the electronic device can be shortened, and a distance between the charging coil and a stylus can be shortened, thereby helping increase a coupling amount between the charging coil and the stylus, and effectively improving charging efficiency of the charging coil.

In a possible implementation, the second circuit board is a printed circuit board.

According to a second aspect of this application, an electronic device is provided, including a housing, an antenna, and the circuit board assembly according to any one of the foregoing. The antenna includes a radiator, and the radiator has a clearance area. The circuit board assembly is located in the housing, and a portion of a first circuit board and a first spring contact in the circuit board assembly are located in the clearance area.

The electronic device includes the foregoing circuit board assembly, and the circuit board assembly has low ground impedance and high reliability of a ground connection, making it less prone to a case such as intermittent contact or poor contact. This can effectively reduce or avoid poor contact of the antenna of the electronic device, thereby effectively improving operation reliability and stability of the antenna of the electronic device, and thus improving communication experience of a user.

In a possible implementation, the housing has a metal frame, and at least a portion of the metal frame forms the radiator.

One end, located in the clearance area, of the first circuit board is disposed close to the metal frame.

In a possible implementation, the housing includes a battery cover and a middle frame.

The battery cover covers the middle frame, the battery cover and the middle frame jointly enclose accommodation space, and the circuit board assembly is located in the accommodation space.

The middle frame has the metal frame.

In a possible implementation, the middle frame includes the metal frame and a metal middle plate. The metal frame is insulated from the metal middle plate, and the first spring contact is electrically connected to the metal middle plate. Alternatively, the first spring contact is electrically connected to a second circuit board in the circuit board assembly.

In a possible implementation, the antenna is a high-power antenna with a power greater than or equal to 25 dB.

In a possible implementation, the antenna is a satellite communication antenna.

### BRIEF DESCRIPTION OF DRAWINGS

FIG. 1 is a diagram of a structure of an electronic device according to an embodiment of this application;
FIG. 2 is an exploded view of a circuit board assembly according to an embodiment of this application;
FIG. 3 is a sectional view taken along B-B in FIG. 1;
FIG. 4 is a diagram of stacking of a first circuit board assembly according to an embodiment of this application;
FIG. 5 is a diagram of a structure of an exposed metal surface according to an embodiment of this application;
FIG. 6 is a diagram of a structure of a second circuit board assembly according to an embodiment of this application;
FIG. 7 is a diagram of stacking of a second circuit board assembly according to an embodiment of this application;
FIG. 8 is a diagram of a structure of a third circuit board assembly according to an embodiment of this application;
FIG. 9 is a diagram of stacking of a third circuit board assembly according to an embodiment of this application;
FIG. 10 is a diagram of a structure of a fourth circuit board assembly according to an embodiment of this application;
FIG. 11 is a diagram of stacking of a fourth circuit board assembly according to an embodiment of this application;
FIG. 12 is a diagram of a structure of a fifth circuit board assembly according to an embodiment of this application;
FIG. 13 is a diagram of stacking of a fifth circuit board assembly according to an embodiment of this application;
FIG. 14 is a diagram of a structure of a sixth circuit board assembly according to an embodiment of this application; and
FIG. 15 is a diagram of a structure of a seventh circuit board assembly according to an embodiment of this application.

### Descriptions of reference numerals:

100: circuit board assembly;
110: first circuit board; 111: main body portion; 112: extension portion; 1121: first extension portion; 1122: second extension portion;
113: bent portion; 114: metal layer; 115: insulation layer; 116: exposed metal surface;
120: first spring contact;
130: bracket; 131: first surface; 132: second surface;
140: reinforcing structure;
150: conductive layer; 151: first conductive layer; 152: second conductive layer;
160: second circuit board;
170: second spring contact;
180: insulating adhesive;
190: charging coil;
200: electronic device; 210: housing; 211: battery cover; 212: middle frame; 2121: metal middle plate; 2122: metal frame; 213: accommodation cavity;
220: antenna;
230: stylus; and
240: display screen.

### DESCRIPTION OF EMBODIMENTS

Terms used in implementations of this application are merely used to explain specific embodiments of this application, but are not intended to limit this application.

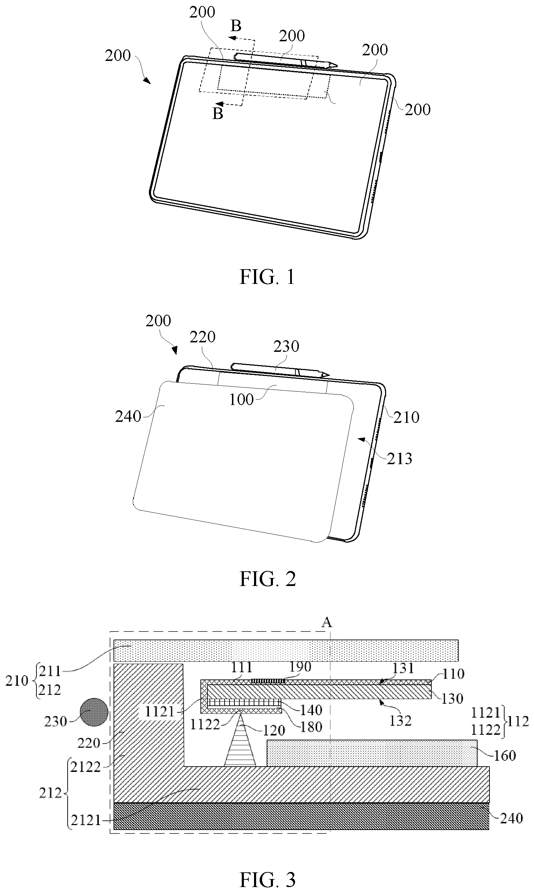

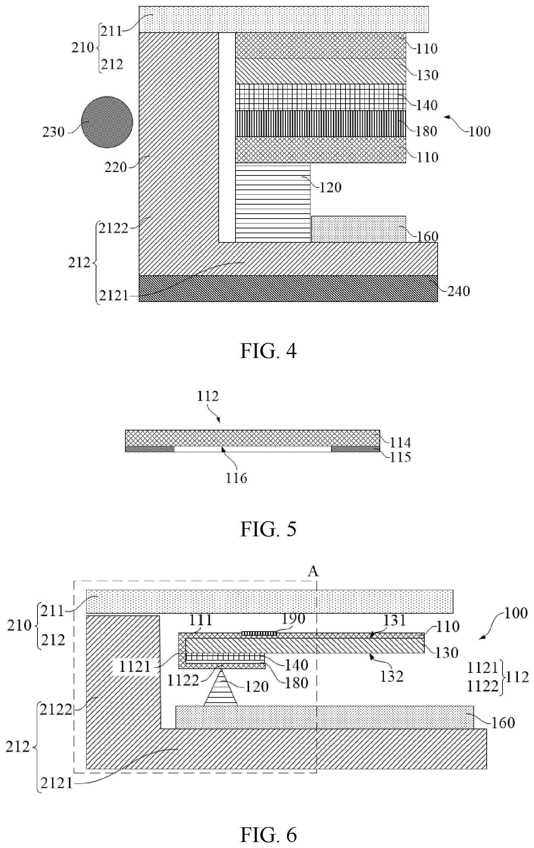

FIG. 1 is a diagram of a structure of an electronic device according to an embodiment of this application. FIG. 2 is an exploded view of a circuit board assembly according to an embodiment of this application. FIG. 3 is a sectional view taken along B-B in FIG. 1. FIG. 4 is a diagram of stacking of a first circuit board assembly according to an embodiment of this application.

Embodiments of this application provide a circuit board assembly and an electronic device that includes the circuit board assembly. The electronic device may be an electronic device with an antenna, for example, a mobile phone, a tablet computer, a notebook computer, an ultra-mobile personal computer (ultra-mobile personal computer, UMPC), a handheld computer, a walkie-talkie, a netbook, a POS machine, a personal digital assistant (personal digital assistant, PDA), a wearable device, a virtual reality device, or a vehicle-mounted apparatus.

The following uses an example in which the electronic device 200 is a tablet computer for description. With reference to FIG. 1, the electronic device 200 may include a housing 210 and an antenna 220. The housing 210 serves as a carrier of the electronic device 200, and all components forming the electronic device 200 may be disposed in the housing 210 or on the housing 210.

For example, a display screen 240 may be disposed on the housing 210. The display screen 240 may be used for display. For example, the display screen may be configured to play videos and display image information such as photos, to facilitate viewing by a user. With reference to FIG. 2, the housing 210 may have an accommodation cavity 213, and a circuit board assembly 100 may be located in the accommodation cavity 213 of the housing 210. Components such as a battery (not shown in the figure) and a mainboard (not shown in the figure) may be further disposed in the housing 210, to implement a complete function of the electronic device 200.

The antenna 220 may have a radiator, and the radiator may be configured to transmit and receive signals, so that the electronic device 200 can perform communication. For example, with reference to FIG. 3 and FIG. 4, the housing 210 may have a metal frame 2122, and at least a portion of the metal frame 2122 may form the radiator of the antenna 220. As the radiator of the antenna 220, the metal frame 2122 may be further configured to transmit and receive signals while implementing a function of carrying the housing 210, thereby eliminating the need to additionally dispose the radiator of the antenna 220 in the electronic device 200. This helps improve utilization of the housing 210 and improve a spatial layout of the electronic device 200.

For example, the housing 210 may include a battery cover 211 and a middle frame 212. The battery cover 211 may be a rear cover of the electronic device 200. The battery cover 211 may cover the middle frame 212, and the battery cover 211 and the middle frame 212 may jointly enclose accommodation space. The circuit board assembly 100 may be located in the accommodation space. The middle frame 212 may have the metal frame 2122 to form the radiator of the antenna 220.

For example, with reference to FIG. 3 and FIG. 4, the middle frame 212 may include the metal frame 2122 and a metal middle plate 2121. The metal frame 2122 may be disposed to be insulated from the metal middle plate 2121. For example, the metal frame 2122 and the metal middle plate 2121 may be formed as an integral structure through injection molding or the like, and the metal frame 2122 and the metal middle frame 2121 are insulated from each other through an injection-molded structure. Alternatively, the metal frame 2122 and the metal middle plate 2121 may be of a split structure. There may be a structural member such as an insulating strip or insulating member between the metal middle plate 2121 and the metal frame 2122, to isolate the metal frame 2122 serving as the radiator of the antenna 220 from the metal middle plate 2121. In this way, impact of the metal middle plate 2121 on radiation of the antenna 220 can be reduced or avoided, thereby helping improve operation reliability and stability of the antenna 220.

The radiator may have a clearance area A. For example, the clearance area A may be a dashed-line box area A in FIG. 1 and FIG. 2. The clearance area A of the antenna 220 is an area around the antenna in which no ground plane is disposed. A function of the clearance area A is mainly to keep metal away from an antenna body (for example, the radiator), so as to prevent the metal from being excessively close to the antenna and affecting radiation efficiency of the antenna.

The antenna 220 may be a high-power antenna. For example, power of the antenna 220 may be greater than or equal to 25 dB. For example, the antenna 220 may be a satellite communication antenna. Satellite communication has a large communication range. In a coverage area of radio waves transmitted by a satellite, communication can be performed between any two points. Satellite communication is not easily affected by terrestrial disasters and has high reliability.

Alternatively, in some examples, the antenna 220 may be a conventional communication antenna, a Wi-Fi antenna, or the like.

One end of the circuit board assembly 100 may be disposed close to the metal frame 2122 of the housing 210. For example, a portion of the circuit board assembly 100 may be located in the clearance area A of the antenna 220. For example, the circuit board assembly 100 may be a wireless charging component, and the circuit board assembly 100 may be configured to charge a stylus of the electronic device 200. For example, the electronic device 200 may further include a stylus 230 (with reference to FIG. 2). In a charging process of the stylus 230, the stylus 230 may be disposed close to the metal frame 2122 of the electronic device 200, to be close to the circuit board assembly 100, so that the circuit board assembly 100 may charge the stylus 230.

The circuit board assembly 100 is disposed close to the clearance area A of the antenna 220. Because the power of the antenna 220 is high, a signal transmitted or received by the antenna 220 is radiated to the circuit board assembly 100, thereby affecting the radiation efficiency of the antenna 220. In addition, radiation of the signal from the antenna 220 to the circuit board assembly 100 adversely affects the circuit board assembly 100. In a related technology, a solder pillar is disposed in the circuit board assembly 100. A circuit board is grounded through the solder pillar, to allow a current to return, thereby reducing impact of the circuit board assembly 100 on the radiation efficiency of the antenna 220.

However, in the foregoing grounding manner of the circuit board assembly, ground impedance of the circuit board assembly is high. In addition, the grounding of the circuit board assembly implemented through the solder pillar has poor connection reliability and is prone to poor contact, thereby generating a passive intermodulation effect. The PIM effect means that in an active component, two or more frequencies are mixed together in a non-linear component, thereby generating a spurious signal. When the spurious intermodulation signal falls within a receiving frequency band of the antenna, sensitivity of the antenna is reduced, thereby affecting normal operation of the antenna and degrading communication experience of a user.

To resolve the foregoing problem, in this application, a structure of a circuit board assembly is improved. A first spring contact is disposed in the circuit board assembly and grounding is implemented through the first spring contact, so that current return is achieved. The first spring contact has elasticity, so that reliability and stability of an electrical connection between the first spring contact and a first circuit board can be effectively improved, and ground impedance of the circuit board assembly can be effectively reduced. In addition, the first spring contact can further effectively avoid problems such as poor contact that may occur in a grounding process of the circuit board assembly, and avoid a PIM effect caused by the poor contact, thereby effectively improving operation reliability and stability of an antenna, and thus improving communication experience of a user.

The circuit board assembly provided in embodiments of this application is described below in detail with reference to the accompanying drawings.

An embodiment of this application provides a circuit board assembly 100. With reference to FIG. 3 and FIG. 4, the circuit board assembly 100 may include a first circuit board 110. The first circuit board 110 may be disposed in an electronic device 200. For example, the first circuit board 110 may be used for wireless charging, and the first circuit board 110 may charge a stylus 230 of the electronic device 200.

A portion of the first circuit board 110 may be located in a clearance area A of an antenna 220 of the electronic device 200, and the first circuit board 110 may be close to a frame of the electronic device 200. In this way, a distance between the first circuit board 110 and the stylus 230 can be shortened, and an electromagnetic coupling amount of wireless charging between the stylus 230 and the first circuit board 110 can be effectively increased, thereby effectively improving efficiency of charging the stylus 230 at the frame of the electronic device 200 by the first circuit board 110.

The circuit board assembly 100 may further include a first spring contact 120. The first spring contact 120 may be located in the clearance area A of the antenna 220, one end of the first spring contact 120 may be electrically connected to the portion, located in the clearance area A, of the first circuit board 110, and the other end of the first spring contact 120 may be configured to be grounded. For example, the other end of the first spring contact 120 may be electrically connected to a middle frame 212 of the electronic device 200, to implement grounding. Alternatively, the other end of the first spring contact 120 may be electrically connected to a mainboard of the electronic device 200, to implement grounding.

For example, the first spring contact 120 may be an elastic component and is elastic. When the first spring contact 120 is electrically connected to the first circuit board 110, the first spring contact 120 may be in a compressed state. The first spring contact 120 in the compressed state has a restoring force. The restoring force may drive the first spring contact 120 into close contact with the first circuit board 110, thereby reducing or avoiding separation between the first spring contact 120 and the first circuit board 110, and effectively improving reliability and stability of the electrical connection between the first spring contact 120 and the first circuit board.

A signal on the antenna 220 may be radiated to the portion, located in the clearance area A, of the first circuit board 110, and the signal current may return through the first spring contact 120, to reduce or avoid adverse impact of the current on the first circuit board 110 on normal radiation of the antenna 220, thereby effectively improving radiation efficiency of the antenna 220. In addition, after the current radiated from the antenna 220 to the first circuit board 110 returns, adverse impact of the radiated signal on the circuit board assembly 100 can be further reduced or avoided, thereby effectively improving operation stability and reliability of the circuit board assembly 100.

Compared with a grounding manner in a related technology, in this embodiment of this application, the first spring contact 120 is disposed in the circuit board assembly 100 and grounding is implemented through the first spring contact 120, so that current return is achieved. The first spring contact 120 has elasticity, so that reliability and stability of the electrical connection between the first spring contact 120 and the first circuit board 110 can be effectively improved, and ground impedance of the circuit board assembly 100 can be effectively reduced. In addition, the first spring contact 120 can further effectively avoid problems such as poor contact that may occur in a grounding process of the circuit board assembly 100, and avoid a PIM effect caused by the poor contact, thereby effectively improving operation reliability and stability of the antenna 220, and thus improving communication experience of a user.

Still with reference to FIG. 3 and FIG. 4, a charging coil 190 may be disposed on the first circuit board 110. The charging coil 190 may be configured to charge the stylus 230 of the electronic device 200. For example, the charging coil 190 may be a hall element (hall element). The charging coil 190 may be located on the first circuit board 110, and at least a portion of the charging coil 190 may be located in the clearance area A of the antenna 220. In this way, a distance between the charging coil 190 and the frame of the electronic device 200 can be shortened, and a distance between the charging coil 190 and the stylus 230 can be shortened, thereby helping increase a coupling amount between the charging coil 190 and the stylus 230, and effectively improving charging efficiency of the charging coil 190.

Still with reference to FIG. 3 and FIG. 4, the circuit board assembly 100 may further include a bracket 130. The bracket 130 may include a first surface 131 and a second surface 132 opposite to each other. At least a portion of the first circuit board 110 may be located on the first surface 131 of the bracket 130. For example, one portion of the first circuit board 110 may be located on the first surface 131 of the bracket 130, and the other portion may be located on one side of the second surface 132 of the bracket 130. The second surface 132 of the bracket 130 may face the first spring contact 120. For example, the first surface 131 of the bracket 130 may face one side of a battery cover 211 of the electronic device 200, and the second surface 132 may face one side of a metal middle plate 2121.

The first circuit board 110 may be insulated from and connected to the bracket 130. For example, the first circuit board 110 may be bonded to the bracket 130 through an insulating adhesive 180 layer. Alternatively, the bracket 130 may be a plastic bracket 130. In this case, the bracket 130 has an insulating property and may not need to be bonded through an insulating adhesive. For example, the first circuit board 110 may be connected to the bracket 130 through a common bonding layer, to reduce connection costs between the bracket 130 and the first circuit board 110.

It should be noted that the bracket 130 shown in the cross-section in FIG. 3 is in a suspended state. In an actual application process, the bracket 130 may be connected to another structural member of the electronic device 200, to implement mounting and fastening of the bracket 130. For example, the bracket 130 may be connected to the mainboard of the electronic device 200 through a connecting component such as a screw, to implement mounting and fastening of the bracket 130. Alternatively, in some examples, the bracket 130 may be further connected to the battery cover 211 of the electronic device 200, to implement fastening of the bracket 130.

The bracket 130 may support the first circuit board 110, so that the first circuit board 110 is in a flattened state, which can effectively reduce or avoid bending deformation of the first circuit board 110. In this way, it can be convenient to arrange an electronic element on the first circuit board 110, and reliability and stability of disposing the electronic element on the first circuit board 110 can be improved.

For example, the first circuit board 110 may be a flexible printed circuit (flexible printed circuit, FPC for short). The flexible printed circuit is flexible, can be freely bent and folded, and can be arbitrarily arranged and adjusted based on use requirements, thereby meeting use requirements of different scenarios and providing high flexibility.

In this embodiment of this application, the bracket 130 may be a plastic bracket. For example, the bracket 130 may be formed by using a material such as plastic and in a manner such as injection molding or stamping. The bracket 130 made of plastic is lightweight and has low costs, which can effectively reduce an overall weight of the circuit board assembly 100 and thus lower material costs of the circuit board assembly 100.

In addition, the bracket 130 made of plastic has a good insulating property, which can insulate and isolate the first circuit board 110, reduce or avoid circuit conduction between the first circuit board 110 and other components, and prevent the conduction between the first circuit board 110 and the other components from affecting normal operation of the circuit board assembly 100, thereby helping improve overall operation reliability and stability of the circuit board.

Still with reference to FIG. 3 and FIG. 4, in a possible implementation, the first circuit board 110 may include a main body portion 111 and an extension portion 112. The main body portion 111 may be located on the first surface 131 of the bracket 130 and be insulated from and connected to the first surface 131 of the bracket 130, and one end of the main body portion 111 may be located in the clearance area A of the antenna 220. One end of the extension portion 112 may be connected to the one end, located in the clearance area A, of the main body portion 111, and the other end of the extension portion 112 may extend toward the second surface 132 of the bracket 130.

For example, the first circuit board 110 may be bent to form the extension portion 112 at one end of the main body portion 111 through bending. The first spring contact 120 may be electrically connected to the extension portion 112. For example, the first spring contact 120 may abut against the extension portion 112, and the first spring contact 120 has a restoring force. The restoring force may enable the first spring contact 120 to be pressed tightly against the extension portion 112, so that current conduction can be performed between the extension portion 112 and the first spring contact 120.

A radiated signal from the antenna 220 may be radiated to the one end, located in the clearance area A of the antenna 220, of the main body portion 111. A current signal radiated to the main body portion 111 may flow from the main body portion 111 to the extension portion 112, then flow from the extension portion 112 to the first spring contact 120, and finally return through the first spring contact 120, thereby achieving current return on the first circuit board 110.

Still with reference to FIG. 3 and FIG. 4, in an example, the extension portion 112 may include a first extension portion 1121 and a second extension portion 1122 connected to each other. One end of the first extension portion 1121 may be connected to the main body portion 111 of the first circuit board 110, and the first extension portion 1121 may extend from the first surface 131 of the bracket 130 toward the second surface 132 of the bracket 130. For example, it may be understood that the first extension portion 1121 is located on a side surface of the bracket 130.

The first extension portion 1121 may be connected to the side surface of the bracket 130. For example, the first extension portion 1121 may be connected to the side surface of the bracket 130 through bonding. This can effectively reduce or avoid a case such as bulging or lifting on a part of the first extension portion 1121, and help improve firmness and reliability of the connection between the first circuit board 110 and the bracket 130, thereby effectively improving overall structural stability of the circuit board assembly 100.

The second extension portion 1122 may be located on the second surface 132 of the bracket 130 and is insulated from and connected to the second surface 132. For example, for the second extension portion 1122, one end may be connected to the first extension portion 1121, and the other end may extend from the first extension portion 1121 along the second surface 132 of the bracket 130, and the second extension portion 1122 may be located in the clearance area A of the antenna 220.

The first spring contact 120 may be electrically connected to the second extension portion 1122. For example, the first spring contact 120 may abut against the second extension portion 1122, and the restoring force of the first spring contact 120 may enable the first spring contact 120 to be pressed tightly against the second extension portion 1122, so that current conduction can be performed between the second extension portion 1122 and the first spring contact 120.

A signal current on the antenna 220 may be radiated to the one end, located in the clearance area A, of the main body portion 111, then sequentially flow from the main body portion 111 to the first extension portion 1121 and the second extension portion 1122, and finally flow from the second extension portion 1122 to the first spring contact 120, thereby returning through the first spring contact 120.

FIG. 5 is a diagram of a structure of an exposed metal surface according to an embodiment of this application.

With reference to FIG. 5, a surface, facing the first spring contact 120, of the second extension portion 1122 may have an exposed metal surface 116, and the first spring contact 120 may be electrically connected to the exposed metal surface 116. For example, with reference to FIG. 5, the first circuit board 110 may include a metal layer 114 (for example, a copper layer) and an insulation layer 115 with which a surface of the metal layer 114 is coated. A portion of the insulation layer 115 on the second extension portion 1122 may be removed. For example, the insulation layer 115 may be ground off to expose the metal layer 114 beneath the insulation layer 115, thereby forming the exposed metal surface 116. The first spring contact 120 may abut against the exposed metal layer 114 (that is, the exposed metal surface 116), to be electrically connected to the second extension portion 1122, so that current conduction can be performed between the second extension portion 1122 and the first spring contact 120.

The radiated current on the main body portion 111 may flow to the second extension portion 1122, and then flow to the first spring contact 120 through the exposed metal surface 116 on the second extension portion 1122, to return through the first spring contact 120. The exposed metal surface 116 can effectively improve the reliability and stability of the electrical connection between the first spring contact 120 and the first circuit board 110, and can effectively reduce or avoid a case such as intermittent contact or poor contact between the first spring contact 120 and the first circuit board 110, thereby effectively improving stability of current return on the first circuit board 110.

Still with reference to FIG. 4, the circuit board assembly 100 may further include a reinforcing structure 140. The reinforcing structure 140 may be located between the second extension portion 1122 and the second surface 132 of the bracket 130, and the reinforcing structure 140 may be connected to the second extension portion 1122 and the second surface 132 of the bracket 130. For example, one surface of the reinforcing structure 140 may be connected to the second surface 132 of the bracket 130, and the other surface may be connected to the second extension portion 1122.

In a process in which the first spring contact 120 is electrically connected to the second extension portion 1122, the restoring force of the first spring contact 120 may be sequentially applied to the reinforcing structure 140 and the bracket 130. The reinforcing structure 140 has high rigidity and strength, is not easy to deform, and can provide rigid support for the bracket 130. This can effectively reduce or avoid deformation of the bracket 130 and the second extension portion 1122 under the restoring force of the first spring contact 120, effectively prevent the deformation of the bracket 130 and the second extension portion 1122 from affecting the electrical connection between the second extension portion 1122 and the first spring contact 120, and avoid intermittent contact caused by poor contact between the second extension portion 1122 and the first spring contact 120. In this way, reliability and stability of the electrical connection between the first spring contact 120 and the second extension portion 1122 can be effectively improved, thereby effectively improving stability of current conduction between the first circuit board 110 and the first spring contact 120, and improving reliability of current return.

For example, the reinforcing structure 140 may be a reinforcement steel sheet. The steel sheet has high strength and rigidity, and can provide good rigid support for the bracket 130. This can effectively reduce or avoid deformation of the bracket 130, and prevent the deformation of the bracket 130 from affecting the electrical connection between the first circuit board 110 and the first spring contact 120, thereby effectively improving the reliability and the stability of the electrical connection between the first spring contact 120 and the first circuit board 110.

Still with reference to FIG. 4, the circuit board assembly 100 may further include an insulating adhesive 180. The reinforcing structure 140 and the second extension portion 1122 may be insulated and connected through the insulating adhesive 180. For example, the insulating adhesive 180 may be located between the reinforcing structure 140 and the second extension portion 1122. One surface of the insulating adhesive 180 may be bonded to the reinforcing structure 140, and the other surface may be bonded to the second extension portion 1122, so that the reinforcing structure 140 may be connected to the second extension portion 1122 through the insulating adhesive 180.

The insulating adhesive 180 can effectively reduce or avoid separation between the second extension portion 1122 and the reinforcing structure 140, and can effectively improve reliability and stability of the connection between the second extension portion 1122 and the reinforcing structure 140, thereby effectively improving overall structural stability of the circuit board assembly 100.

The reinforcing structure 140 and the bracket 130 may also be insulated and connected through an insulating adhesive layer, to reduce or avoid separation between the reinforcing structure 140 and the bracket 130, thereby effectively improving reliability and stability of the connection between the reinforcing structure 140 and the bracket 130, and improving structural stability of the circuit board assembly 100.

Still with reference to FIG. 4, in a possible implementation, the other end of the first spring contact 120 may be configured to be electrically connected to the middle frame 212 of the electronic device 200, to implement grounding. For example, the first spring contact 120 may be located between the first circuit board 110 and the metal middle plate 2121 of the middle frame 212, and one end of the first spring contact 120 may abut against the first circuit board 110 to implement an electrical connection to the first circuit board 110. The other end of the first spring contact 120 may abut against the metal middle plate 2121 of the electronic device 200, to implement an electrical connection to the metal middle plate 2121.

The current radiated from the antenna 220 to the first circuit board 110 may flow to the first spring contact 120, and then flow to the middle frame 212 of the electronic device 200 through the first spring contact 120, thereby achieving current return.

Still with reference to FIG. 4, the circuit board assembly 100 may further include a second circuit board 160. The second circuit board 160 may be the mainboard of the electronic device 200. The second circuit board 160 may be located on the middle frame 212. The second circuit board 160 may be electrically connected to the first circuit board 110, to charge the charging coil 190 on the first circuit board 110. For example, the second circuit board 160 may be a printed circuit board, and the charging coil 190 on the first circuit board 110 may be electrically connected to the second circuit board 160, so that the second circuit board 160 may supply power to the charging coil 190, and the charging coil 190 may charge the stylus 230 of the electronic device 200.

It should be noted that in the part shown in the cross-section in FIG. 4, the second circuit board 160 and the first circuit board 110 are disconnected from each other. In an actual application process, the second circuit board 160 and the first circuit board 110 may be electrically connected in another part. For example, there may be a connector between the first circuit board 110 and the second circuit board 160, and the first circuit board 110 and the second circuit board 160 may be electrically connected through the connector.

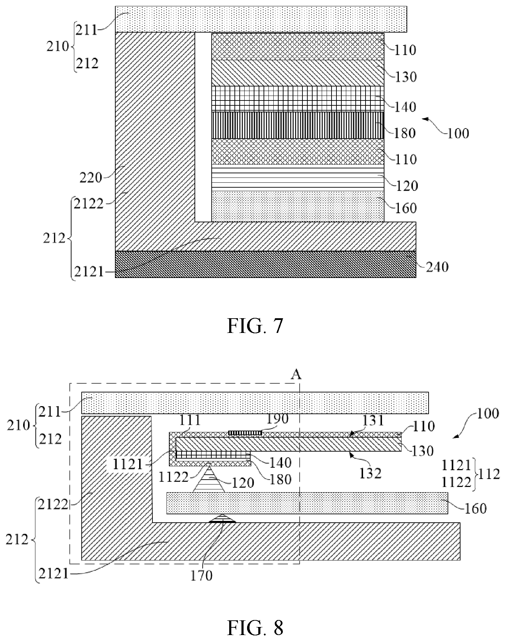

FIG. 6 is a diagram of a structure of a second circuit board assembly according to an embodiment of this application. FIG. 7 is a diagram of stacking of a second circuit board assembly according to an embodiment of this application.

In another possible implementation, with reference to FIG. 6 and FIG. 7, the first spring contact 120 may be located between the first circuit board 110 and the second circuit board 160, and the other end of the first spring contact 120 may be electrically connected to the second circuit board 160. The first spring contact 120 may be grounded through the second circuit board 160, so that a radiated current on the first circuit board 110 may sequentially return through the first spring contact 120 and the second circuit board 160, to avoid adverse impact of the radiated current on the first circuit board 110 on normal radiation of the antenna 220.

A difference between the embodiment shown in FIG. 6 and the embodiment shown in FIG. 4 lies in that the first spring contact 120 in FIG. 4 is electrically connected to the metal middle plate 2121 in the middle frame 212 and is grounded through the metal middle plate 2121, while the first spring contact 120 in FIG. 6 is electrically connected to the second circuit board 160 and is grounded through the second circuit board 160, to achieve current return.

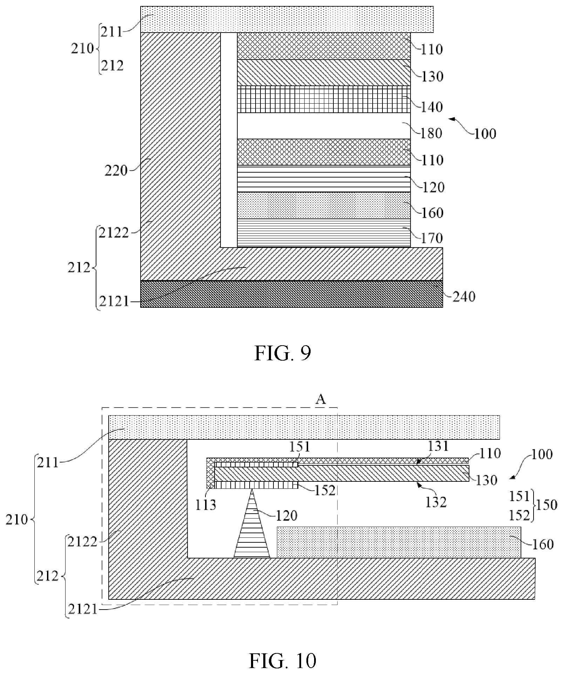

FIG. 8 is a diagram of a structure of a third circuit board assembly according to an embodiment of this application. FIG. 9 is a diagram of stacking of a third circuit board assembly according to an embodiment of this application.

Alternatively, in still another possible implementation, with reference to FIG. 8 and FIG. 9, the second circuit board 160 may be further electrically connected to the middle frame 212, to be grounded through the middle frame 212. For example, the circuit board assembly 100 may further include a second spring contact 170. One end of the second spring contact 170 may be electrically connected to the second circuit board 160, and the other end of the second spring contact 170 may be configured to be grounded to the middle frame 212 of the electronic device 200. In this way, the current radiated from the antenna 220 to the first circuit board 110 may flow to the first spring contact 120, flow to the second circuit board 160 through the first spring contact 120, and then return to the middle frame 212 through the second spring contact 170, to avoid adverse impact of the radiated current on the first circuit board 110 on normal radiation of the antenna 220.

For example, the second spring contact 170 may be located between the second circuit board 160 and the middle frame 212 of the electronic device 200. The second spring contact 170 may be an elastic component, and the second spring contact 170 may be in a compressed state between the second circuit board 160 and the middle frame 212. The second spring contact 170 in the compressed state has a restoring force. The restoring force may drive the second spring contact 170 to be pressed tightly against the second circuit board 160 and the middle frame 212, so that the second spring contact 170 remains in close contact with the second circuit board 160 and the middle frame 212, and is electrically connected to the second circuit board 160 and the middle frame 212.

In this way, reliability and stability of the electrical connection between the second spring contact 170 and each of the second circuit board 160 and the middle frame 212 can be effectively improved, and a case such as poor contact or intermittent contact between the second spring contact 170 and each of the second circuit board 160 and the middle frame 212 can be effectively reduced or avoided, thereby effectively improving reliability and stability of grounding of the second spring contact 170.

A difference between the embodiment shown in FIG. 8 and the embodiment shown in FIG. 6 lies in that the first spring contact 120 in FIG. 6 is electrically connected to the second circuit board 160 and is grounded through the second circuit board 160, to achieve current return, while the second circuit board 160 in FIG. 8 is further electrically connected to the middle frame 212 through the second spring contact 170, and finally grounded through the middle frame 212, to achieve current return.

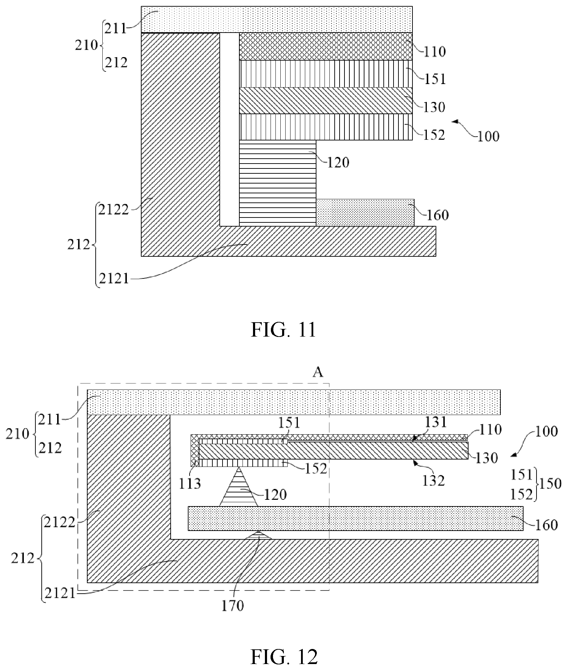

FIG. 10 is a diagram of a structure of a fourth circuit board assembly according to an embodiment of this application. FIG. 11 is a diagram of stacking of a fourth circuit board assembly according to an embodiment of this application.

In another possible implementation, with reference to FIG. 10 and FIG. 11, the circuit board assembly 100 may further include a conductive layer 150. One end of the conductive layer 150 may be electrically connected to the first circuit board 110, and the other end may be electrically connected to the first spring contact 120. At least a portion of the conductive layer 150 may be located in the clearance area A of the antenna 220. For example, the first spring contact 120 may be electrically connected to the portion, located in the clearance area A of the antenna 220, of the conductive layer 150.

For example, one end of the conductive layer 150 may be located between the first circuit board 110 and the first surface 131 of the bracket 130, and is electrically connected to the first circuit board 110. For example, the conductive layer 150 may be electrically connected to the first circuit board 110 through soldering. For example, the insulation layer 115 on the first circuit board 110 may be removed to expose the metal layer 114 (that is, the copper layer) beneath the insulation layer 115. The conductive layer 150 may be soldered to the copper layer, to implement an electrical connection to the first circuit board 110, so that current conduction can be performed between the conductive layer 150 and the first circuit board 110.

The other end of the conductive layer 150 may be folded to the second surface 132 of the bracket 130 and connected to the second surface 132 of the bracket 130. For example, the conductive layer 150 may be connected to the first surface 131 and the second surface 132 of the bracket 130 through bonding. A portion, located on the second surface 132 of the bracket 130, of the conductive layer 150 may be electrically connected to the first spring contact 120. For example, under the restoring force, the first spring contact 120 may be pressed tightly against a surface, facing away from the bracket 130, of the conductive layer 150, so that current conduction can be performed between the first spring contact 120 and the conductive layer 150.

A current radiated from the antenna 220 to the first circuit board 110 may flow to the conductive layer 150, then flow to the first spring contact 120 through the conductive layer 150, and finally return to ground through the first spring contact 120. The conductive layer 150 has good conductivity, which can effectively improve ground impedance between the first circuit board 110 and the first spring contact 120, thereby effectively improving efficiency of current return on the first circuit board 110.

In the circuit board assembly 100, the reinforcing structure 140 is omitted, so that a structural layer in the circuit board assembly 100 can be reduced. This can effectively reduce an overall thickness of the circuit board assembly 100, facilitate a thinning design of the circuit board assembly 100, and effectively reduce space occupied by the circuit board assembly 100 in the electronic device 200, thereby facilitating a lightweight and thin design of the electronic device 200.

For example, the conductive layer 150 may be a nickel-gold layer. The nickel-gold layer has good conductivity, which can effectively improve ground impedance between the conductive layer 150 and the first spring contact 120, thereby effectively improving efficiency of current return on the first circuit board 110. In addition, the nickel-gold layer has good oxidation resistance, which can effectively reduce or avoid oxidation of the conductive layer 150, thereby helping improve stability and reliability of the conductive layer 150.

A difference between the embodiment shown in FIG. 10 and the embodiment shown in FIG. 8 lies in that the first circuit board 110 in FIG. 8 extends and is folded to the second surface 132 of the bracket 130 to form the extension portion 112, and then is electrically connected through abutting between the extension portion 112 and the first spring contact 120, while in the circuit board assembly 100 in FIG. 10, the conductive layer 150 for conducting electricity is disposed on the first surface 131 and the second surface 132 of the bracket 130, and then the first circuit board 110 and the first spring contact 120 are separately electrically connected to the conductive layer 150, so that the first circuit board 110 is electrically connected to the first spring contact 120.

Still with reference to FIG. 10 and FIG. 11, in a possible implementation, the conductive layer 150 may include a first conductive layer 151 and a second conductive layer 152. The first conductive layer 151 may be electrically connected to the second conductive layer 152, and the first conductive layer 151 may be located between the first surface 131 of the bracket 130 and the portion, located in the clearance area A, of the first circuit board 110, and is electrically connected to the first circuit board 110.

For example, the first conductive layer 151 may be electrically connected to the portion, located in the clearance area A, of the first circuit board 110. For example, the first conductive layer 151 may be electrically connected to the portion, located in the clearance area A, of the first circuit board 110 through soldering.

The second conductive layer 152 may be located between the second surface 132 of the bracket 130 and the first spring contact 120, and is electrically connected to the first spring contact 120. For example, one surface of the second conductive layer 152 may be bonded to the second surface 132 of the bracket 130, and the first spring contact 120 may abut against and be pressed tightly against the other surface of the second conductive layer 152, to be electrically connected to the second conductive layer 152.

It should be noted that in the part shown in the cross-section in FIG. 10, the first conductive layer 151 and the second conductive layer 152 are in a disconnected state. In an actual application process, the conductive layer 150 may be of an integral structure, one portion of the conductive layer 150 may be located on the first surface 131 of the bracket 130 to form the first conductive layer 151, and the other portion of the conductive layer 150 may pass through the side surface of the bracket 130 and be folded to the second surface 132 of the bracket 130 to form the second conductive layer 152.

Alternatively, the conductive layer 150 may be a gold-plated layer. For example, the conductive layer 150 may be plated on the first surface 131, the side surface, and the second surface 132 of the bracket 130 through electroplating or the like, and the gold-plated layers on the first surface 131, the side surface, and the second surface 132 of the bracket 130 are interconnected, so that the gold-plated layers on the first surface 131 and the second surface 132 of the bracket 130 can be conducted to implement current conduction.

When the conductive layer 150 is a gold-plated layer, the gold-plated layer is plated on a surface of the bracket 130, and a thickness of the bracket 130 is almost not increased. In this way, the circuit board assembly 100 may have an overall reduced thickness, and the thinning design of the circuit board assembly 100 may be effectively improved.

In this way, the current radiated from the antenna 220 to the first circuit board 110 may first flow to the first conductive layer 151, then flow to the second conductive layer 152 through the first conductive layer 151, then flow to the first spring contact 120 through the second conductive layer 152, and finally return to ground through the first spring contact 120. The first conductive layer 151 and the second conductive layer 152 have good conductivity and low impedance, which can reduce connection impedance between the first circuit board 110 and the first spring contact 120, and help reduce ground impedance of the circuit board assembly 100, thereby improving efficiency of ground return of the circuit board assembly 100.

Still with reference to FIG. 10 and FIG. 11, in this embodiment, a grounding manner of the first spring contact 120 may be that an electrical connection to the middle frame 212 of the electronic device 200 is implemented, to implement grounding through the middle frame 212 of the electronic device 200, as shown in FIG. 10. In this case, after flowing to the first spring contact 120, the current radiated from the antenna 220 to the first circuit board 110 may flow to the middle frame 212 of the electronic device 200 through the first spring contact 120, to achieve current return. Alternatively, for a grounding manner of the first spring contact 120, refer to FIG. 6 in which an electrical connection to the second circuit board 160 is implemented, and then grounding is implemented through the second circuit board 160.

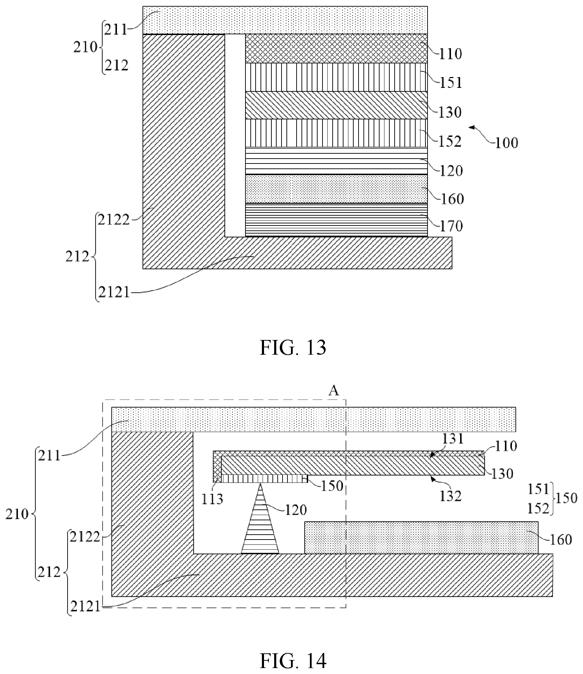

FIG. 12 is a diagram of a structure of a fifth circuit board assembly according to an embodiment of this application. FIG. 13 is a diagram of stacking of a fifth circuit board assembly according to an embodiment of this application.

Alternatively, with reference to FIG. 12 and FIG. 13, the first spring contact 120 in this embodiment may be electrically connected to the second circuit board 160, as shown in FIG. 12, and the second circuit board 160 may be electrically connected to the middle frame 212 of the electronic device 200, to implement grounding through the middle frame 212. In this case, after flowing to the first spring contact 120, the current radiated from the antenna 220 to the first circuit board 110 may flow to the second circuit board 160 through the first spring contact 120, and then flow to the middle frame 212 of the electronic device 200 through the second circuit board 160, to achieve current return.

For example, with reference to FIG. 12, the second circuit board 160 may be electrically connected to the middle frame 212 of the electronic device 200 through the second spring contact 170, so that the second circuit board 160 may be closely connected to the middle frame 212. In this way, reliability and stability of the electrical connection between the second circuit board 160 and the middle frame 212 can be effectively improved, and a case such as poor contact or intermittent contact between the second circuit board 160 and the middle frame 212 can be effectively reduced or avoided, thereby effectively improving reliability of current return on the first circuit board 110.

A difference between the embodiment shown in FIG. 12 and the embodiment shown in FIG. 10 lies in different grounding manners of the first spring contact 120. The first spring contact 120 in FIG. 10 is electrically connected to the middle frame 212, to implement grounding, while the first spring contact 120 in FIG. 12 is electrically connected to the second circuit board 160, and then the second circuit board 160 is electrically connected to the middle frame 212, to implement grounding.

FIG. 14 is a diagram of a structure of a sixth circuit board assembly according to an embodiment of this application.

In still another possible implementation, with reference to FIG. 14, the conductive layer 150 may be located on the second surface 132 of the bracket 130, and located between the second surface 132 of the bracket 130 and the first spring contact 120. A surface of the conductive layer 150 may be connected to the second surface 132 of the bracket 130. For example, the conductive layer 150 may be connected to the second surface 132 of the bracket 130 through bonding. A surface, facing away from the second surface 132 of the bracket 130, of the conductive layer 150 may be electrically connected to the first spring contact 120, to implement grounding through the first spring contact 120. For example, the first spring contact 120 may abut against the surface, facing away from the second surface 132 of the bracket 130, of the conductive layer 150, and is electrically connected to the conductive layer 150.

One end of the conductive layer 150 may be electrically connected to the first circuit board 110. In this way, a current radiated from the antenna 220 to the first circuit board 110 may first flow to the one end of the conductive layer 150, then flow to the first spring contact 120 through the conductive layer 150, and finally return to ground through the first spring contact 120.

For example, still with reference to FIG. 14, there may be a bent portion 113 at one end, located in the clearance area A of the antenna 220, of the first circuit board 110. The bent portion 113 may extend from the first surface 131 of the bracket 130 toward the second surface 132 of the bracket 130, and the one end of the conductive layer 150 may be electrically connected to the first circuit board 110 through the bent portion 113. For example, the bent portion 113 may be located on the side surface of the bracket 130, so that the conductive layer 150 is electrically connected to the bent portion 113. Alternatively, the conductive layer 150 may extend to the side surface of the bracket 130, to be electrically connected to the bent portion 113.

For example, one end of the conductive layer 150 may be connected to the bent portion 113 through soldering. For example, the insulation layer 115 on the bent portion 113 may be removed to expose the copper layer beneath the insulation layer 115. The one end of the conductive layer 150 may be soldered to the copper layer, to implement an electrical connection to the bent portion 113.

In this way, the current radiated from the antenna 220 to the first circuit board 110 may first flow to the bent portion 113 of the first circuit board 110, then flow to the conductive layer 150 through the bent portion 113 of the first circuit board 110, then flow to the first spring contact 120 through the conductive layer 150, and finally return to ground through the first spring contact 120.

A difference between the embodiment shown in FIG. 14 and the embodiment shown in FIG. 10 lies in different manners of disposing the conductive layer 150 on the bracket 130. In FIG. 10, the conductive layer 150 is disposed on both the first surface 131 and the second surface 132 of the bracket 130, while in FIG. 14, the conductive layer 150 is disposed only on the second surface 132 of the bracket 130.

In this embodiment, still with reference to FIG. 14, the first spring contact 120 may be electrically connected to the middle frame 212 of the electronic device 200, as shown in FIG. 14, to be grounded through the middle frame 212 of the electronic device 200. In this case, the current radiated from the antenna 220 to the first circuit board 110 may sequentially flow to the bent portion 113 and the conductive layer 150, and then flow to the first spring contact 120, and the current flowing to the first spring contact 120 may flow to the middle frame 212 of the electronic device 200, to achieve current return.

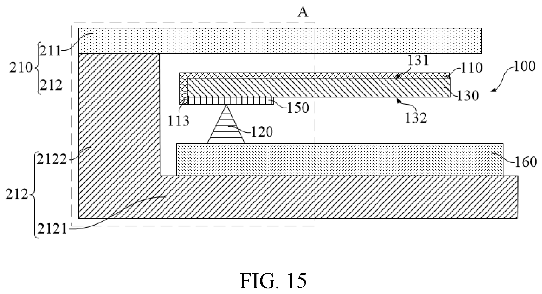

FIG. 15 is a diagram of a structure of a seventh circuit board assembly according to an embodiment of this application.

Alternatively, with reference to FIG. 15, the first spring contact 120 in this embodiment may be electrically connected to the second circuit board 160, as shown in FIG. 15, and then grounded through the second circuit board 160. For example, the second circuit board 160 may be electrically connected to the middle frame 212 of the electronic device 200, to implement grounding through the middle frame 212. In this case, after flowing to the first spring contact 120, the current radiated from the antenna 220 to the first circuit board 110 may flow to the second circuit board 160 through the first spring contact 120, and then flow to the middle frame 212 of the electronic device 200 through the second circuit board 160, to achieve current return.

For example, still with reference to FIG. 15, the second circuit board 160 may be electrically connected to the middle frame 212 of the electronic device 200 through the second spring contact 170, so that the second circuit board 160 may be closely connected to the middle frame 212. In this way, reliability and stability of the electrical connection between the second circuit board 160 and the middle frame 212 can be effectively improved, and a case such as poor contact or intermittent contact between the second circuit board 160 and the middle frame 212 can be effectively reduced or avoided, thereby effectively improving reliability of current return on the first circuit board 110.

In the descriptions of embodiments of this application, it should be noted that unless otherwise clearly specified and limited, the terms "mounting", "interconnection", and "connection" should be understood in a broad sense. For example, there may be a fixed connection, may be an indirect connection through an intermediate medium, or may be an internal connection between two elements or an interaction relationship between two elements. A person of ordinary skill in the art may understand specific meanings of the foregoing terms in embodiments of this application based on specific cases. The terms "first", "second", "third", "fourth", and the like (if any) are used to distinguish between similar objects, and are not necessarily used to describe a specific sequence or order.

Finally, it should be noted that the foregoing embodiments are merely used to describe the technical solutions in embodiments of this application, but not to limit this application. Although embodiments of this application are described in detail with reference to the foregoing embodiments, a person of ordinary skill in the art should understand that modifications may still be made to the technical solutions described in the foregoing embodiments or equivalent replacements may be made to some or all technical features thereof, and these modifications or replacements do not cause the essence of the corresponding technical solutions to depart from the scope of the technical solutions in embodiments of this application.

## Claims

1. A circuit board assembly, comprising:
a first circuit board, configured to be disposed in an electronic device, wherein a portion of the first circuit board is located in a clearance area of an antenna of the electronic device; and
a first spring contact, wherein the first spring contact is located in the clearance area, one end of the first spring contact is electrically connected to the portion, located in the clearance area, of the first circuit board, and the other end of the first spring contact is configured to be grounded.

2. The circuit board assembly according to claim 1, further comprising a bracket, wherein the bracket comprises a first surface and a second surface opposite to each other;
at least a portion of the first circuit board is located on the first surface of the bracket, and the second surface faces the first spring contact; and
the first circuit board is insulated from and connected to the bracket.

3. The circuit board assembly according to claim 2, wherein the first circuit board comprises a main body portion and an extension portion;
the main body portion is located on the first surface and is insulated from and connected to the first surface, and one end of the main body portion is located in the clearance area;
one end of the extension portion is connected to the one end, located in the clearance area, of the main body portion, and the other end of the extension portion extends toward the second surface of the bracket; and
the one end of the first spring contact is electrically connected to the extension portion.

4. The circuit board assembly according to claim 3, wherein the extension portion comprises a first extension portion and a second extension portion connected to each other;
one end of the first extension portion is connected to the main body portion, and the first extension portion extends from the first surface of the bracket toward the second surface;
the second extension portion is located on the second surface of the bracket and is insulated from and connected to the second surface; and
the first spring contact is electrically connected to the second extension portion.

5. The circuit board assembly according to claim 4, wherein a surface, facing the first spring contact, of the second extension portion has an exposed metal surface, and the first spring contact is electrically connected to the exposed metal surface.

6. The circuit board assembly according to claim 4 or 5, further comprising a reinforcing structure, wherein the reinforcing structure is located between the second extension portion and the second surface of the bracket, and is connected to the second extension portion and the second surface of the bracket.

7. The circuit board assembly according to claim 6, further comprising an insulating adhesive, wherein the reinforcing structure is insulated from and connected to the second extension portion through the insulating adhesive.

8. The circuit board assembly according to claim 2, further comprising a conductive layer, wherein one end of the conductive layer is electrically connected to the first circuit board;
the other end of the conductive layer is electrically connected to the first spring contact; and
at least a portion of the conductive layer is configured to be located in the clearance area.

9. The circuit board assembly according to claim 8, wherein the conductive layer comprises a first conductive layer and a second conductive layer, and the first conductive layer is electrically connected to the second conductive layer;
the first conductive layer is located between the first surface of the bracket and the portion, located in the clearance area, of the first circuit board, and is electrically connected to the first circuit board; and
the second conductive layer is located between the second surface of the bracket and the first spring contact, and is electrically connected to the first spring contact.

10. The circuit board assembly according to claim 8, wherein the conductive layer is located on the second surface of the bracket and is located between the second surface of the bracket and the first spring contact; and
the conductive layer is electrically connected to the first spring contact.

11. The circuit board assembly according to claim 10, wherein there is a bent portion at one end, located in the clearance area, of the first circuit board; and
the bent portion extends from the first surface of the bracket toward the second surface of the bracket, and the one end of the conductive layer is electrically connected to the first circuit board through the bent portion.

12. The circuit board assembly according to any one of claims 8 to 11, wherein the conductive layer is a nickel-gold layer.

13. The circuit board assembly according to any one of claims 2 to 12, wherein the bracket is a plastic bracket.

14. The circuit board assembly according to any one of claims 1 to 13, further comprising a second circuit board, wherein the first spring contact is located between the first circuit board and the second circuit board, the other end of the first spring contact is electrically connected to the second circuit board, and the first spring contact is grounded through the second circuit board.

15. The circuit board assembly according to claim 14, further comprising a second spring contact, wherein one end of the second spring contact is electrically connected to the second circuit board, and the other end of the second spring contact is configured to be grounded to a middle frame of the electronic device.

16. The circuit board assembly according to any one of claims 1 to 13, wherein the other end of the first spring contact is configured to be electrically connected to a middle frame of the electronic device, to implement grounding.

17. The circuit board assembly according to any one of claims 1 to 16, wherein the first circuit board is a flexible printed circuit.

18. The circuit board assembly according to any one of claims 1 to 17, further comprising a charging coil, wherein the charging coil is located on the first circuit board, and at least a portion of the charging coil is configured to be located in the clearance area.

19. The circuit board assembly according to claim 14 or 15, wherein the second circuit board is a printed circuit board.

20. An electronic device, comprising:
a housing;
an antenna, wherein the antenna comprises a radiator, and the radiator has a clearance area; and
the circuit board assembly according to any one of claims 1 to 19, wherein the circuit board assembly is located in the housing, and a portion of a first circuit board and a first spring contact in the circuit board assembly are located in the clearance area.

21. The electronic device according to claim 20, wherein the housing has a metal frame, and at least a portion of the metal frame forms the radiator; and
one end, located in the clearance area, of the first circuit board is disposed close to the metal frame.

22. The electronic device according to claim 21, wherein the housing comprises a battery cover and a middle frame;
the battery cover covers the middle frame, the battery cover and the middle frame jointly enclose accommodation space, and the circuit board assembly is located in the accommodation space; and
the middle frame has the metal frame.

23. The electronic device according to claim 22, wherein the middle frame comprises the metal frame and a metal middle plate, the metal frame is insulated from the metal middle plate, and the first spring contact is electrically connected to the metal middle plate; or
the first spring contact is electrically connected to a second circuit board in the circuit board assembly.

24. The electronic device according to any one of claims 20 to 23, wherein the antenna is a high-power antenna with a power greater than or equal to 25 dB.

25. The electronic device according to any one of claims 20 to 24, wherein the antenna is a satellite communication antenna.
